(19) **Europäisches Patentamt / European Patent Office / Office européen des brevets**

(11) **EP 1 016 142 B1**

(12) **EUROPEAN PATENT SPECIFICATION**

(45) Date of publication and mention
of the grant of the patent:
**04.11.2009 Bulletin 2009/45**

(51) Int Cl.:
***H01L 29/24*** *(2006.01)*   ***H01L 29/06*** *(2006.01)*

(21) Application number: **98931179.0**

(22) Date of filing: **26.06.1998**

(86) International application number:
**PCT/SE1998/001255**

(87) International publication number:
**WO 1999/000849 (07.01.1999 Gazette 1999/01)**

(54) **SiC SEMICONDUCTOR DEVICE COMPRISING A PN JUNCTION**

SiC HALBLEITERBAUELEMENT MIT EINEM PN-ÜBERGANG

DISPOSITIF SEMI-CONDUCTEUR AU SiC COMPRENANT UNE JONCTION PN

(84) Designated Contracting States:
**CH DE FR GB IT LI SE**

(30) Priority: **26.06.1997 US 883106**

(43) Date of publication of application:
**05.07.2000 Bulletin 2000/27**

(73) Proprietor: **CREE, INC.**
**Charlotte, NC 27703 (US)**

(72) Inventors:
 • **BAKOWSKI, Mietek**
 **S-151 60 Södertälje (SE)**
 • **GUSTAFSSON, Ulf**
 **S-589 25 Linköping (SE)**
 • **HARRIS, Christopher**
 **S-194 72 Sollentuna (SE)**

(74) Representative: **Olsson, Jan et al**
**Bjerkéns Patentbyra KB**
**P.O.Box 1274**
**801 37 Gävle (SE)**

(56) References cited:
**WO-A1-95/04374      WO-A1-96/03774**
**WO-A1-96/21246      US-A- 4 375 125**
**US-A- 5 486 718**

• **IEEE TRANSACTIONS ON ELECTRON DEVICES, Volume ED-23, No. 8, August 1976, TAKESHI MATSUSHITA et al., "Highly Reliable High-Voltage Transistors by Use of the SIPOS Process", pages 826-830.**

**Description**

TECHNICAL FIELD

The invention relates to a semiconductor device of planar structure according to the preamble of appended claim 1.

BACKGROUND ART

Semiconductor devices based on silicon carbide as base material are continuously developed to be used in connection with high temperatures, high power applications and under high radiation conditions. Under such circumstances conventional semiconductors do not work satisfactorily. Evaluations indicate that SiC semiconductors of power MISFET-type and diode rectifiers based on SiC would be able to operate over a greater voltage and temperature interval, e.g. up to 650 - 800 °C, and show better switching properties such as lower losses and higher working frequencies and nevertheless have a volume 20 times smaller than corresponding silicon devices. These possible improvements are based on the favorable material properties that silicon carbide possesses in relation to silicon, such e.g. a higher breakdown field (up to 10 times higher than silicon), a higher thermal conductivity (more than 3 times higher than silicon) and a higher energy band gap (2.86 eV for 6H-SiC, one of the crystal structures of SiC).

SiC semiconductor technology is relatively young and in many aspects immature. There are many critical manufacturing problems that are to be solved until SiC semiconductor devices may be realized experimentally and large scale manufacturing may become a reality. This is especially true of devices intended for use in high-power and high-voltage applications.

One of the difficulties to overcome when manufacturing high voltage diodes or other types of semiconductor devices comprising a voltage absorbing pn junction is to produce a proper junction termination at the edge of the junction. The electric field at the periphery of the junction is normally enhanced compared to the electric field in the bulk of the junction. This field increase at the periphery of the junction may be further reinforced in the presence of surface charge. A high electric field at the edge of the pn junction implies a great risk of voltage breakdown or flash-over at the edge of the junction as well as giving rise to an instability of the blocking voltage known as voltage drift.

To avoid the above-mentioned disadvantages it becomes very important to reduce the field concentration, where the junction reaches the surface. Combined with efforts to passivate the surface of the device, measures are taken to flatten out the electric field at the surface e.g. by acting on how the pn junction emerges at the surface. As an example it is known from silicon power devices to lap (grind, sandblast, etch) the surface of the edge to a certain angle in relation to the pn junction to thereby flatten out the field. Another known technique is to gradually decrease the charge content on the highly doped side of the junction, in such a way that the charge content of the highly doped layer is reduced towards the outermost edge of the junction, a so called Junction Termination Extension, (JTE). The methods, known from silicon technology, used to achieve a JTE of an Si device cannot always be directly transferred to devices with SiC as base material, primarily due to the great hardness of SiC and extremely low diffusivity of proper SiC dopants. Ion implantation of doping elements, a common technique when manufacturing Si devices, is difficult to master and not yet fully developed for SiC but is still perhaps the most promising method for doping of SiC. However, ion implantation introduces damage to the SiC crystal, which is a factor to be considered.

High voltage diodes from 6H-SiC with epitaxially formed pn and Schottky junctions have been made experimentally (see e.g. M. Bhatnagar and B. J. Baliga, IEEE Trans. Electron Devices, Vol. 40, No. 3 pp 645 - 655, March 1993 or P. G. Neudeck, D. J. Larkin, J. A. Powell, L. G. Matus and C. S. Salupo, Appl. Phys. Lett. Vol 64, No 11, 14 March 1994, pp 1386-1388). Some of the problems related to SiC devices have thus been solved, but no reliable solution to the problems connected with electric field concentration at the edges of the junction has been presented as yet.

Any method or device to accomplish a semiconductor device corresponding to the principle of Junction Termination Extension at a pn junction composed of Si is not publicly known for a device, where SiC constitutes the base material of the junction. Solutions for arriving at SiC devices comprising pn junctions with planar JTEs are described in the unpublished patent application US 08/683 059, which is hereby included in this description by reference. The solutions described there involve stepwise decreasing charges of the JTE towards the edge by ion implantation of concentric regions, also called zones, of the JTE in order to control the surface doping and surface fields. A consecutive passivating layer has to be grown or deposited on a surface which is structurally damaged by the ion implantation.

WO-A-96 03774 describes an n or p-doped semiconductor region that accepts the depletion region of an active section of a semiconductor component with a vertical expansion depending on an applied blocking voltage. The edge termination for the active region takes the form of a semiconductor with the opposite doping to the semiconductor region immediately adjacent to the active region or in a surface of the semiconductor region. The lateral expansion of the edge termination is greater than the maximum vertical expansion of the depletion region and the semiconductor region and the edge termination are formed by a semiconductor with a band spacing of at least 2 eV.

US-A-5486718 discloses a semiconductor structure having an edge termination feature wherein a first doped region and a second doped region are selectively formed in a semiconductor layer. The second doped region is coupled with the first doped region and has an impurity concentration less than that of the first doped region. An insulating layer is disposed over the semiconductor layer and over at least a portion of the second doped region. A conductive layer, having a coil-shaped configuration, is disposed over the insulating layer and is coupled to the semiconductor layer.

WO-A-9504374 concerns an integrated circuit (IC) that is formed on a semiconductor substrate. The IC has a pn junction and a graded junction termination. A reverse field plate is mounted adjacent the junction termination. One end of the field plate is mounted on and electrically connected to the substrate; the remainder of the field plate extends over a passivating oxide layer which covers the substrate surface adjacent the junction termination. The field plate provides a common potential surface which maintains a fixed potential on the substrate surface at the junction termination.

WO-A-9621246 relates to a semiconductor device comprises at least one semiconductor layer of SiC and a layer applied on at least a portion of an edge surface of said SiC-layer so as to passivate this edge surface portion. At least the portion of said passivation layer closest to said edge surface portion of the SiC-layer is made of a first crystalline material, and the passivation layer comprises a portion made of a second material having AIN as only component or as a major component of a crystalline alloy constituting said second material.

US-A-4375125 describes the surface termination of a p-n junction of a semiconductor device that is passivated with semi-insulating material which is deposited on a thin layer of insulating material formed at the bared semiconductor surface by a chemical conversion treatment at a temperature above room temperature. The layer may be formed by oxidizing the semiconductor material of the body for example in dry oxygen between 300°C. and 500°C or in an oxidizing liquid containing for example hydrogen peroxide or nitric acid at for example 80°C. The layer is sufficiently thin to permit conduction (e.g. by tunnelling) between the semi-insulating material and the surface but thick enough to reduce said conduction so that when the junction is reverse-biased leakage current flows further along the semi-insulating material before flowing out to the surface across the layer. This increases the spread of the junction depletion layer along the surface thereby permitting a high breakdown voltage even with a high resistivity for the material. The thin layer can also act as a barrier against gettering of lifetime-killers (e.g. gold) from the semiconductor body by the semi-insulating material. The semi-insulating material may be based on amorphous or polycrystalline silicon or a chalcogenide.

DESCRIPTION OF THE INVENTION

The present invention aims at describing a JTE structure of an SiC device where the pn junction and its JTE has a planar structure and where the described problems are avoided. Another aim of the invention is also to minimize the electric field at the surface of the component. A low lateral electric field at the interface of a device surface to a passivation layer is vital to the proper function of the device. Unnecessary electric field peaks may be detrimental to the short- and long-term stability of the device.

This aim is reached by providing a semiconductor device of the type defined in appended claim 1.

One aspect of the invention is composed of a planar structure semiconductor device which comprises a pn junction. Both a p-conducting layer and an n-conducting layer forming the pn junction consist of doped silicon carbide. The edge of the higher doped conducting layer of the pn junction exhibits a charge profile with a stepwise or uniformly decreasing effective sheet charge density. The effective sheet charge density is radially decreasing from an initial value at the periphery of a main junction area to a zero or almost zero effective sheet charge density at the outermost edge of a junction extension. Characteristic of the invention is that the mentioned pn junction with its junction termination extension is buried under a third layer, which is a layer of SiC that might be doped or undoped. This third layer is an epitaxially grown layer.

The effective sheet charge density is equal to the integral of the volume doping concentration over the thickness of the JTE zone or third layer. In the case of constant doping concentration, the effective sheet charge density is equal to the product of the doping concentration and the thickness of the doped layer.

By manufacturing a device with the features as specified in claim 1 a damage free third layer, i.e. an epitaxial layer is provided for the passivation step in the manufacturing of, e.g., a transistor. The third layer will result in lower peaks in the electric field and reduced stress on the passivation layer.

Characteristic of the invention is that the third layer may be either p-conducting or n-conducting and according to one preferred embodiment epitaxially grown.

Another aspect of the invention is that the third layer may itself be used as a zone of the JTE as specified in claim 4. Thus, the number of process steps may be minimized for a given reduction of the electric field. Further aspects of the invention include the fact that a number of zones may be ion implanted into the third layer as specified in claim 5.

Yet another aspect of the invention is that the device may be covered with a passivating layer.

When manufacturing e.g. a MISFET, JFET, FCT or an IGBT, the third layer may be used as the drift region, the base region or the channel region, depending on device type.

Other aspects of the invention further comprise methods as defined in the independent claim 10 for producing the above-mentioned SiC semiconductor device.

BRIEF DESCRIPTION OF THE DRAWINGS

Figure 1 shows a planar pn junction with ion implanted zones as JTE of the device. The pn junction and its JTE are buried under a third layer, in the figure exemplified as an epitaxial layer, being of the same conducting type as the JTE.

Figure 2 shows a planar pn junction with ion implanted zones as parts of the JTE of the device. The pn junction is buried under a third layer, in the figure exemplified as an epitaxial layer, being of the same conducting type as the JTE, where the third layer serves as the outermost zone of the JTE.

Figure 3 shows a planar pn junction with ion implanted zones as parts of the JTE of the device. The pn junction is buried under a third layer being of the same conducting type as the JTE. The outermost zone of the JTE is implanted into the third layer.

Figure 4 shows a device similar to the one in fig. 1, where the third layer is of the same conducting type as the substrate.

Figure 5 shows a device similar to the one in fig. 2, where the third layer is of the same conducting type as the substrate.

Figure 6 shows a device similar to the one in fig. 3, where the third layer is of the same conducting type as the substrate.

Figure 7 shows the electric field at the surface of a device, as a function of the distance from the pn junction, without the third layer.

Figure 8 shows the electric field at the surface of a device, as a function of the distance from the pn junction, for a two-zone JTE when a third layer, e.g. an epitaxially grown layer, is present.

Figure 9 shows the electric field at the surface of a device, as a function of the distance from the pn junction, for a three-zone JTE when the third layer constitutes the third zone.

DESCRIPTION OF EMBODIMENTS

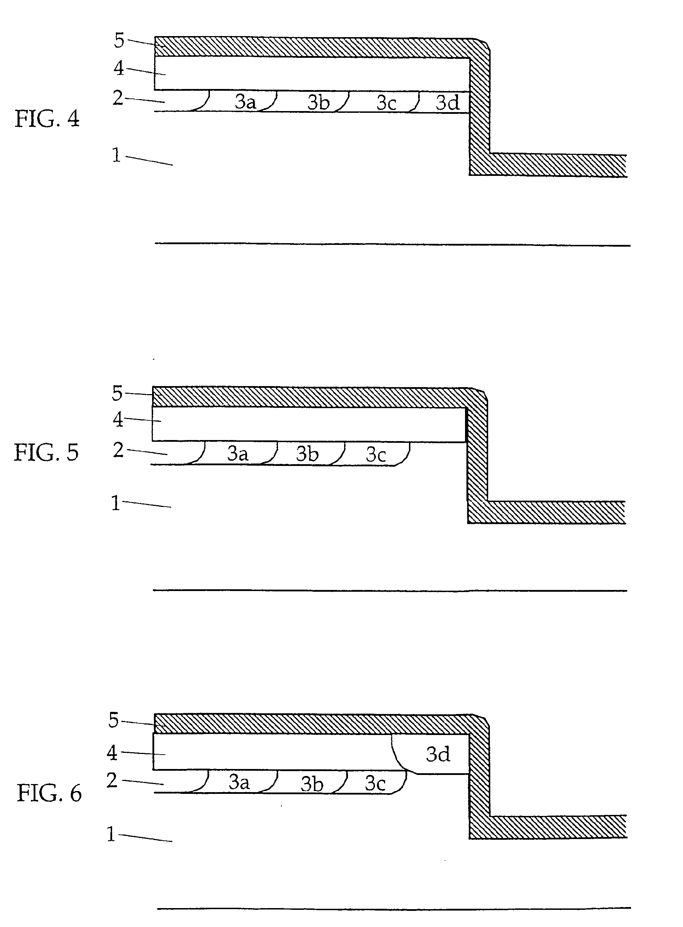

The invention will be described in a number of embodiments with reference to the drawings.

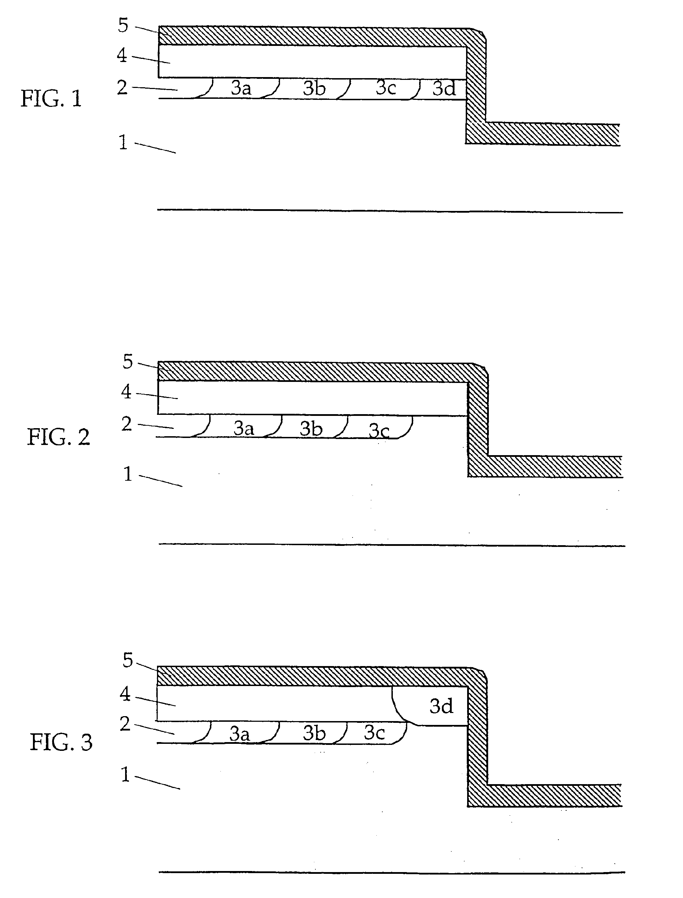

Figure 1 illustrates a planar device having a JTE buried under third epitaxial layer according to the invention. The semiconductor device is exemplified by a pn junction, where silicon carbide constitutes the base material.
The manufacturing of a planar JTE, as described below, is not new. The planar JTE as described below is included in the description of the invention so as to clarify the use of the invention.
The devices shown in figures 1 and 4 exemplify a first embodiment of the invention. The device in figure 1 is built on a substrate 1 consisting of doped n-conducting SiC. A highly doped p-conducting zone 2 is established employing ion implantation. As implants aluminum, boron or gallium can be used. The n-doped substrate 1 with its p-conducting zone 2 compose a pn-junction where zone 1 constitutes the first layer and zone 2 is a part of the second layer. In a second stage, a JTE 3 is formed employing masking of concentric zones followed by ion implantation. A first zone 3a of the JTE is formed by masking the entire area of the substrate outside zone 3a. During the following ion implantation, zone 3a will become p-doped and zone 2 will become more highly doped. In the next step, everything outside zone 3b is masked and the highly doped zone 2, zone 3a and zone 3b are ion implanted with the result that the resulting doping concentration of zone 3a will be higher than in zone 3b. The doping concentration of zone 3a is a result of two consecutive ion implantations. Further zones of the JTE extension 3c may be formed in consecutive steps by masking everything outside zone 3c followed by ion implantation. Alternatively, a reversed method may be employed. Thus, in a first stage the entire area of the JTE is left unmasked and is ion implanted with a dose equal to the final dose of the outermost zone 3d. In the next step, everything but the outermost zone is being left unmasked and is ion implanted so that the total dose is equal to the final dose in the outermost zone but one. The masking is then repeated for all of the zones of the JTE.
In an alternative embodiment, the substrate 1 may be p-conducting and the implanted zone 2 with its JTE n-conducting.
The resulting charge density of the different zones of the JTE will be decreasing, in a direction from the pn junction to the edge of the device, from an initial value at the pn junction. At the zone boundaries of the JTE, the electric field will reach peak values during operation. The height of these peaks is dependent on the number of zones used and will decrease with an increasing number of zones. In the example above, the JTE consisted of 4 zones. The number of zones is ultimately dependent on the allowed number of process steps. After the JTE has been formed, a third p-doped layer 4, is grown on top of the device. The third p-doped layer 4 is an epitaxially grown layer. As an alternative, the third layer may consist of n-doped material as shown in figure 4. One of the aspects of the invention is that a damage-free layer is supplied for the passivation step in which an optional passivating layer 5 is formed on the third layer 4, this third layer 4 is an epitaxially grown layer. The passivating layer 5 may consist of, e.g., $SiO_2$ or AlN.

A second preferred embodiment of the invention is exemplified in figure 2. In this embodiment the area extension of the JTE is smaller than the extension of the third layer covering zone 2 and its JTE 3a-3c. In forming the zones 3a-3c, the same methods as described above may be employed. The third layer, having a lower concentration of doping atoms than the last implanted zone of the JTE 3, itself serves as the outermost zone of the junction termination extension. In this embodiment the number of process steps is decreased compared with the first embodiment. This embodiment of the invention can also incorporate the passivating layer 5, for further reduction of the electric field, as described above. In this second embodiment, the third layer may consist of either n-doped or p-doped SiC and is an epitaxially grown layer.

A third embodiment of the invention can be exemplified with reference to figures 3 and 5. A device according to this embodiment can be arrived at by starting with the same steps as described for the second preferred embodiment. After the growth or formation of the third layer, a last zone 3d of the JTE is formed by ion implantation, of a dopant of the same conducting type as in zones 3a-3c, into the epitaxial layer. In this third embodiment, the third layer may consist of either n-doped or p-doped SiC and is an epitaxially grown layer.

The pn-junction and its JTE in the examples above may be a part of a buried grid in any of an MISFET, an IGBT, a JFET or an FCT where the third layer constitutes a part of the drift region of said component.

The pn-junction and its JTE in the examples above may be a part of a buried grid in any of a JFET or an FCT where the third layer constitutes a part of the channel region of said component.

Alternatively, the pn junction and its JTE in the examples above may be a part of a buried grid in any of an MISFET or an IGBT and that the third layer constitutes a part of the base region of said component.

In the figures the area extension of the device is terminated by etching. A device according to the invention may also be terminated by an implanted channel stopper.

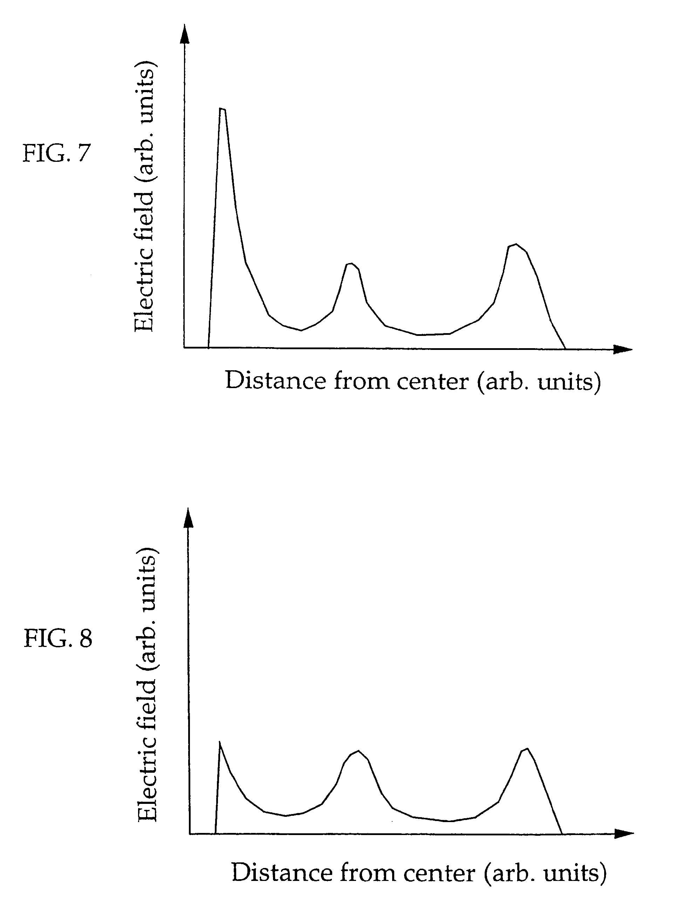

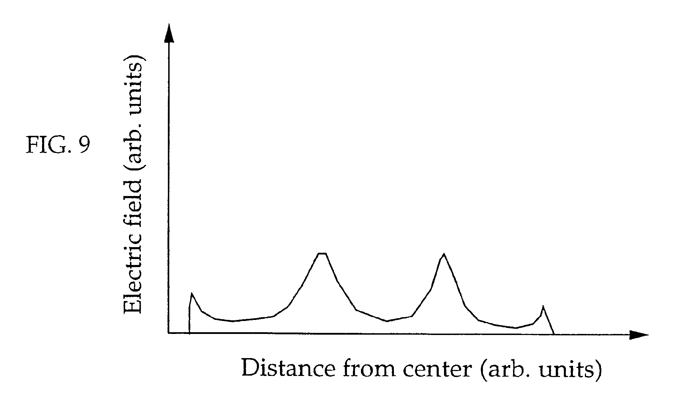

Figure 7 shows the electric field at the surface of a device, as a function of the distance from the pn junction, with a JTE as shown in figure 2, having only 2 zones, without the epitaxially grown layer 4. Figure 8 shows the electric field at the surface of the device, as a function of the distance from the pn junction, for a JTE according to Figure 5 having only 2 zones, when a third layer 4, an epitaxially grown layer, of the opposite conducting type as the JTE, is present. It is evident from the figures that the third layer reduces the height of the peaks in the electric field at the surface of the device. Figure 9 shows the electric field at the surface of the device, as a function of the distance from the pn junction, for a JTE according to Figure 2 having only 3 zones, when the third layer, being of the same conducting type as the JTE, constitutes the third zone of the JTE.

Generally, for a four-zone JTE the charge densities may be varied according to the intervals of the relation

$$Q_1 : Q_2 : Q_3 : Q_4 = (50\text{-}85):(30\text{-}60):(15\text{-}40):(5\text{-}25)$$

where $Q_1$ denotes the effective sheet charge density of the innermost zone of the JTE, $Q_2$ the next to the innermost zone 3b and so on. The value 100 corresponds to a doping such that the zone with this charge density is completely depleted at full design voltage. This charge density is called the characteristic charge density $Q_0$ and is expressed in Coulombs/cm$^2$.

With other alternative number of zones:

three zones: $Q_1 : Q_2 : Q_3 = (40\text{-}85):(25\text{-}50):(5\text{-}35)$.

two zones: $Q_1 : Q_2 = (30\text{-}85):(5\text{-}50)$.

one zone: $Q_1 = (30\text{-}80)$.

For a device with more than 4 zones in the JTE, the ranges as stated above may serve as a guidance.

The doping of the highly doped area of the pn junction being surrounded by the JTE may be several times higher than the characteristic effective sheet charge density $Q_0$.

The effective sheet charge density is equal to the integral of the volume doping concentration over the thickness of the JTE zone or third layer. In the case of constant doping concentration, the effective sheet charge density is equal to the product of the doping concentration and the thickness of the doped layer.

The term SiC is used in the following text to refer to any of the principal crystal polytypes of this material known as 6H, 4H, 2H, 3C and 15R.

## Claims

1. A semiconductor device of planar structure which comprises doped silicon carbide, exhibiting a pn junction, formed of a lower doped first conducting type layer (1) and on top thereof a higher doped second conducting type layer (2) forming the pn junction with said first conducting type layer, the edge of the higher doped layer being provided with an edge termination (3) enclosing stepwise or continuously decreasing effective sheet charge density towards the outer border of the termination, **characterized in that** the second conducting type layer of the pn junction and said edge termination (3) are covered by a third layer (4), said third layer (4) consisting of epitaxial silicon carbide on the second conducting type layer and

2. A semiconductor device according to claim 1, **characterized in that** the third layer (4) is of the first conducting type.

3. A semiconductor device according to claim 1, **characterized in that** the third layer (4) is of the second conducting type.

4. A semiconductor device according to any of claims 1,2 or 3, **characterized in that** the third layer (4) extends, in a direction radially outwards from the center of the pn junction, beyond the extension of said edge termination (3) in the second layer (2), and that the third layer itself serves as the outermost zone of said edge termination.

5. A semiconductor device according to any of claims 1,2 or 3, **characterized in that** the third layer extends, in a direction radially outwards from the center of the pn junction, beyond the extension of said edge termination (3) in the second layer (2), and that there is implanted a last zone of said edge termination in the third layer.

6. A semiconductor device according to any of claims 1 to 5, **characterized in that** the surface of the device is covered with a passivating layer (5).

7. A semiconductor device according to any of claims 1 to 5, **characterized in that** the pn junction and said edge termination are a part of a buried grid in any of a MISFET, an IGBT, a JFET or an FCT and that the third layer constitutes a part of the drift region of said component.

8. A semiconductor device according to any of claims 1 to 5, **characterized in that** the pn junction and said edge termination (3) are a part of a buried grid in any of a JFET or an FCT and that the third layer (4) constitutes a part of the channel region of said component.

9. A semiconductor device according to any of claims 1 to 5, **characterized in that** the pn junction and said edge termination are a part of a buried grid in any of an MISFET or an IGBT and that the third layer constitutes a part of the base region of said component.

10. Method of manufacturing a semiconductor device comprising a planar structure pn junction, starting from an object having on top of each other a lower doped first conducting type silicon carbide layer (1) and a higher doped second conducting type silicon carbide layer (2) forming the pn junction with said first conducting type silicon carbide layer, the edge of the higher doped layer being provided with an edge termination (3) enclosing stepwise or continously decreasing effective sheet charge density towards the outer border of the termination **characterized in that** a third layer (4) of SiC is epitaxially formed on top of the second conducting type layer and said edge termination so as to cover the second conducting type layer and said edge termination.

11. Method according to claim 10, **characterized in that** said third layer (4) is formed on top of said edge termination (3) and on an extension of the second layer radially, outwards from the center of the pn junction, beyond said edge termination in the second layer.

**Patentansprüche**

1. Halbleitervorrichtung mit einem planaren Aufbau, die dotiertes Siliziumcarbid umfasst und einen pn-Übergang aufweist, der aus einer geringer dotierten Schicht (1) vom ersten Leitfähigkeitstyp und darauf einer stärker dotierten Schicht (2) vom zweiten Leitfähigkeitstyp gebildet ist, die den pn-Übergang mit der Schicht vom ersten Leitfähigkeitstyp bildet, wobei der Rand der stärker dotierten Schicht mit einem Randabschluss (3) versehen ist, der eine sich schrittweise oder kontinuierlich verringernde effektive Lagenladungsdichte zu der äußeren Grenze des Abschlusses hin einschließt,
   **dadurch gekennzeichnet, dass** die Schicht vom zweiten Leitfähigkeitstyp des pn-Übergangs und der Randabschluss (3) durch eine dritte Schicht (4) bedeckt sind, wobei die dritte Schicht (4) aus epitaktischem Siliziumcarbid an der Schicht vom zweiten Leitfähigkeitstyp und dem Randabschluss besteht.

2. Halbleitervorrichtung nach Anspruch 1,
   **dadurch gekennzeichnet, dass** die dritte Schicht (4) vom ersten Leitfähigkeitstyp ist.

3. Halbleitervorrichtung nach Anspruch 1,
   **dadurch gekennzeichnet, dass** die dritte Schicht (4) vom zweiten Leitfähigkeitstyp ist.

4. Halbleitervorrichtung nach einem der Ansprüche 1, 2 oder 3,
   **dadurch gekennzeichnet, dass** sich die dritte Schicht (4) von der Mitte des pn-Übergangs in einer Richtung radial nach außen über die Erstreckung des Randabschlusses (3) in der zweiten Schicht (2) hinaus erstreckt, und dass die dritte Schicht selbst als äußerste Zone des Randabschlusses dient.

5. Halbleitervorrichtung nach einem der Ansprüche 1, 2 oder 3,
   **dadurch gekennzeichnet, dass** sich die dritte Schicht von der Mitte des pn-Übergangs in einer Richtung radial nach außen über die Erstreckung des Randabschlusses (3) in der zweiten Schicht (2) hinaus erstreckt, und dass in der dritten Schicht eine letzte Zone des Randabschlusses implantiert ist.

6. Halbleitervorrichtung nach einem der Ansprüche 1 bis 5,
   **dadurch gekennzeichnet, dass** die Oberfläche der Vorrichtung mit einer Passivierungsschicht (5) bedeckt ist.

7. Halbleitervorrichtung nach einem der Ansprüche 1 bis 5,
   **dadurch gekennzeichnet, dass** der pn-Übergang und der Randabschluss Teil eines Buried Grid in einem beliebigen von einem MISFET, einem IGBT, einem JFET oder einem FCT sind, und dass die dritte Schicht einen Teil des Driftgebiets der Komponente bildet.

8. Halbleitervorrichtung nach einem der Ansprüche 1 bis 5,
   **dadurch gekennzeichnet, dass** der pn-Übergang und der Randabschluss (3) Teil eines Buried Grid in einem beliebigen von einem JFET oder einem FCT sind, und dass die dritte Schicht (4) einen Teil des Kanalgebiets der Komponente bildet.

9. Halbleitervorrichtung nach einem der Ansprüche 1 bis 5,
   **dadurch gekennzeichnet, dass** der pn-Übergang und der Randabschluss Teil eines Buried Grid in einem beliebigen von einem MISFET oder einem IGBT sind, und dass die dritte Schicht einen Teil des Basisgebiets der Komponente bildet.

10. Verfahren zum Herstellen einer Halbleitervorrichtung mit einem pn-Übergang mit planarem Aufbau, wobei mit einem Objekt begonnen wird, das übereinander eine geringer dotierte Siliziumcarbidschicht (1) vom ersten Leitfähigkeitstyp und eine stärker dotierte Siliziumcarbidschicht (2) vom zweiten Leitfähigkeitstyp aufweist, die den pn-Übergang mit der Siliziumcarbidschicht vom ersten Leitfähigkeitstyp bildet, wobei der Rand der stärker dotierten Schicht mit einem Randabschluss (3) versehen ist, der eine sich schrittweise oder kontinuierlich verringernde effektive Lagenladungsdichte zu der äußeren Grenze des Abschlusses hin einschließt,
    **dadurch gekennzeichnet, dass** eine dritte Schicht (4) von SiC epitaktisch auf der Schicht vom zweiten Leitfähigkeitstyp und dem Randabschluss gebildet wird, um die Schicht vom zweiten Leitfähigkeitstyp und den Randabschluss zu bedecken.

11. Verfahren nach Anspruch 10,
    **dadurch gekennzeichnet, dass** die dritte Schicht (4) auf dem Randabschluss (3) und an einer Erstreckung der

**EP 1 016 142 B1**

zweiten Schicht radial nach außen von der Mitte des pn-Übergangs über den Randabschluss in der zweiten Schicht hinaus gebildet wird.

**Revendications**

1. Dispositif semi-conducteur de structure plane qui comprend du carbure de silicium dopé, montrant une jonction pn, formée d'une première couche de type passant faiblement dopée (1) et, sur le dessus de celle-ci, d'une seconde couche de type passant fortement dopée (2) formant la jonction pn avec ladite première couche de type passant, le bord de la couche fortement dopée étant muni d'une terminaison de bord (3) enfermant de manière étagée ou continue une densité de charges de feuille effective décroissante vers la bordure externe de la terminaison, **caractérisé en ce que** la seconde couche de type passant de la jonction pn et ladite terminaison de bord (3) sont recouvertes d'une troisième couche (4), ladite troisième couche (4) consistant en du carbure de silicium épitaxial sur la seconde couche de type passant et ladite terminaison de bord.

2. Dispositif semi-conducteur selon la revendication 1, **caractérisé en ce que** la troisième couche (4) est du premier type passant.

3. Dispositif semi-conducteur selon la revendication 1, **caractérisé en ce que** la troisième couche (4) est du second type passant.

4. Dispositif semi-conducteur selon une quelconque des revendications 1, 2 ou 3, **caractérisé en ce que** la troisième couche (4) s'étend, dans une direction radialement vers l'extérieur à partir du centre de la jonction pn, au-delà de l'extension de ladite terminaison de bord (3) dans la seconde couche (2) et **en ce que** la troisième couche elle-même sert en tant que zone la plus externe de ladite terminaison de bord.

5. Dispositif semi-conducteur selon une quelconque des revendications 1, 2 ou 3, **caractérisé en ce que** la troisième couche s'étend, dans une direction radialement vers l'extérieur à partir du centre de la jonction pn, au-delà de l'extension de ladite terminaison de bord (3) dans la seconde couche (2), et **en ce qu'**il est implanté une dernière zone de ladite terminaison de bord dans la troisième couche.

6. Dispositif semi-conducteur selon une quelconque des revendications 1 à 5, **caractérisé en ce que** la surface du dispositif est recouverte d'une couche de passivation (5).

7. Dispositif semi-conducteur selon une quelconque des revendications 1 à 5, **caractérisé en ce que** la jonction pn et ladite terminaison de bord forment une partie d'une grille enfouie dans un quelconque d'un MISFET, d'un IGBT, d'un JFET ou d'un FCT en **en ce que** la troisième couche constitue une partie de la région de migration dudit composant.

8. Dispositif semi-conducteur selon une quelconque des revendications 1 à 5, **caractérisé en ce que** la jonction pn et ladite terminaison de bord (3) forment une partie d'une grille enfouie dans un quelconque d'un JFET ou d'un FCT et **en ce que** la troisième couche (4) constitue une partie de la région de canal dudit composant.

9. Dispositif semi-conducteur selon une quelconque des revendications 1 à 5, **caractérisé en ce que** la jonction pn et ladite terminaison de bord forment une partie d'une grille enfouie dans un quelconque d'un MISFET ou d'un IGBT et **en ce que** la troisième couche constitue une partie de la région de base dudit composant.

10. Procédé de fabrication d'un dispositif semi-conducteur comprenant une jonction pn de structure plane, commençant à partir d'un objet ayant l'une au-dessus de l'autre une première couche de carbure de silicium de type passant faiblement dopée (1) et une seconde couche de carbure de silicium de type passant fortement dopée (2) formant la jonction pn avec ladite première couche de carbure de silicium de type passant, le bord de la couche fortement dopée étant muni d'une terminaison de bord (3) enfermant de façon étagée ou continue une densité de charges de feuille effective décroissante vers la bordure externe de la terminaison, **caractérisé en ce qu'**une troisième couche (4) de SiC est formée de façon épitaxiale sur le dessus de la seconde couche de type passant et ladite terminaison de bord de façon à recouvrir la seconde couche de type passant et ladite terminaison de bord.

11. Procédé selon la revendication 10, **caractérisé en ce que** ladite troisième couche (4) est formée sur le dessus de ladite terminaison de bord (3) et sur une extension de la seconde couche radialement, vers l'extérieur à partir du centre de la jonction pn, au-delà de ladite terminaison de bord dans la seconde couche.

FIG. 1

FIG. 2

FIG. 3

FIG. 4

5

4

2

3a   3b   3c   3d

1

FIG. 5

5

4

2

3a   3b   3c

1

FIG. 6

5

4

2

3a   3b   3c

3d

1

FIG. 7

FIG. 8

FIG. 9

Electric field (arb. units)

Distance from center (arb. units)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 08683059 B
- WO 9603774 A
- US 5486718 A
- WO 9504374 A
- WO 9621246 A
- US 4375125 A

**Non-patent literature cited in the description**

- **M. Bhatnagar ; B. J. Baliga.** *IEEE Trans. Electron Devices,* March 1993, vol. 40 (3), 645-655
- **P. G. Neudeck ; D. J. Larkin ; J. A. Powell ; L. G. Matus ; C. S. Salupo.** *Appl. Phys. Lett.,* 14 March 1994, vol. 64 (11), 1386-1388